## Europäisches Patentamt

## European Patent Office

## Office européen des brevets

(11) Veröffentlichungsnummer: **0 105 403**
**B1**

(12) # EUROPÄISCHE PATENTSCHRIFT

(45) Veröffentlichungstag der Patentschrift:
**07.01.87**

(51) Int. Cl.⁴: **G 01 R 31/28**

(21) Anmeldenummer: **83109342.2**

(22) Anmeldetag: **20.09.83**

(54) **Vorrichtung und Verfahren zur direkten Messung von Signalverläufen an mehreren Messpunkten mit hoher Zeitauflösung.**

(30) Priorität: **27.09.82 DE 3235698**

(43) Veröffentlichungstag der Anmeldung:
**18.04.84 Patentblatt 84/16**

(45) Bekanntmachung des Hinweises auf die Patenterteilung:
**07.01.87 Patentblatt 87/2**

(84) Benannte Vertragsstaaten:
**DE GB NL**

(56) Entgegenhaltungen:
**ELECTRONICS INTERNATIONAL, Band 54, Nr. 14, Juli 1981, Seiten 105-112, New York, US P. FAZEKAS u.a.: "Scanning electron beam probes VLSI chips"
IEEE J SOLID-STATE CIRCUITS, Band SC-13, Nr. 3, Juni 1978, Seiten 319-325, IEEE, New York, US H.-P. FEUERBAUM u.a.: "Quantitative measurement with high time resolution of internal waveforms on MOS RAM's using a modified scanning electron microscope"**

(73) Patentinhaber: **Siemens Aktiengesellschaft Berlin und München, Wittelsbacherplatz 2, D-8000 München 2 (DE)**

(72) Erfinder: **Feuerbaum, Hans-Peter, Dr., Dipl.-Phys., Arno-Assmann-Strasse 14, D-8000 München 83 (DE)**

## Beschreibung

Die Erfindung betrifft eine Vorrichtung zur direkten Messung von Signalverläufen an mehreren Messpunkten auf einer Probe nach dem Oberbegriff des Anspruchs 1 und ein entsprechendes Verfahren.

Mit einem Elektronenstrahl-Messgerät sollen zeitabhängige bzw. speziell periodische Vorgänge in integrierten Schaltungen an einem oder mehreren Messpunkten in Echtzeit gemessen werden. Solche Messpunkte können zum Beispiel Stücke von Leiterbahnen sein.

Besonders aufschlussreiche Hinweise zur Lokalisierung von Fehlern in hochintegrierten Schaltungen erhält man aus Messungen des zeitlichen Signalverlaufes an ausgewählten Knotenpunkten im Innern der zu untersuchenden Bauelemente. Anordnungen zur Durchführung solcher Messungen sind beispielsweise aus den Artikeln von H.P. Feuerbaum: «VLSI Testing Using The Electron Probe» (Scanning Electron Microscopy/1979/I, Seiten 285 bis 296) und «Quantitative Measurement with High Time Resolution of Internal Waveforms . . .» (IEEE J. Solid-State Circuits, Band SC-13, No. 3, Juni 1978, Seiten 319 bis 325) bekannt. Zur Messung des Signalverlaufes positioniert man den in der elektronenoptischen Säule eines modifizierten Rasterelektronenmikroskopes erzeugten Primärelektronenstrahl auf einem Knotenpunkt, und bestimmt die vom Potential des Bauelementes abhängige Verschiebung der Energieverteilung der am jeweiligen Messpunkt ausgelösten Sekundärelektronen in einem elektrostatischen Gegenfeld-Spektrometer. Das zwischen Objektivlinse und Probe angeordnete Spektrometer besteht im wesentlichen aus einer ebenen Absaugelektrode zur Beschleunigung der ausgelösten Sekundärelektronen und einer Elektrodenanordnung zur Erzeugung eines Potentialwalles variabler Höhe. Über eine Rückkopplungsschleife wird hierbei die an der Gegenfeldelektrode anliegende Spannung so nachgeregelt, dass der in einem Detektor nachweisbare Sekundärelektronenstrom konstant bleibt. Wegen der relativ geringen Bandbreite dieser Rückkopplungsschleife können in den bekannten Anordnungen hochfrequente Signale (Frequenz f grösser 2 MHz) allerdings nur stroboskopisch auch dem Sampling-Prinzip abgetastet werden.

Der vorliegenden Erfindung liegt die Aufgabe zugrunde, eine Vorrichtung der eingangs genannten Art anzugeben, mit der schnelle zeitabhängige Vorgänge an einem oder mehreren Messpunkten auf einer Probe in Echtzeit gemessen werden können.

Diese Aufgabe wird erfindungsgemäss durch eine Vorrichtung nach Anspruch 1 bzw. durch ein Verfahren nach Anspruch 2 gelöst. Ausgestaltungen und Vorteile der Erfindung sind in den weiteren Ansprüchen, der Beschreibung und der Zeichnung dargestellt.

Ausführungsbeispiele der Erfindung werden im folgenden anhand der Zeichnung näher erläutert.

Fig. 1 zeigt schematisch eine erfindungsgemässe Vorrichtung.

Fig. 2 erläutert das Prinzip eines erfindungsgemässen Verfahrens.

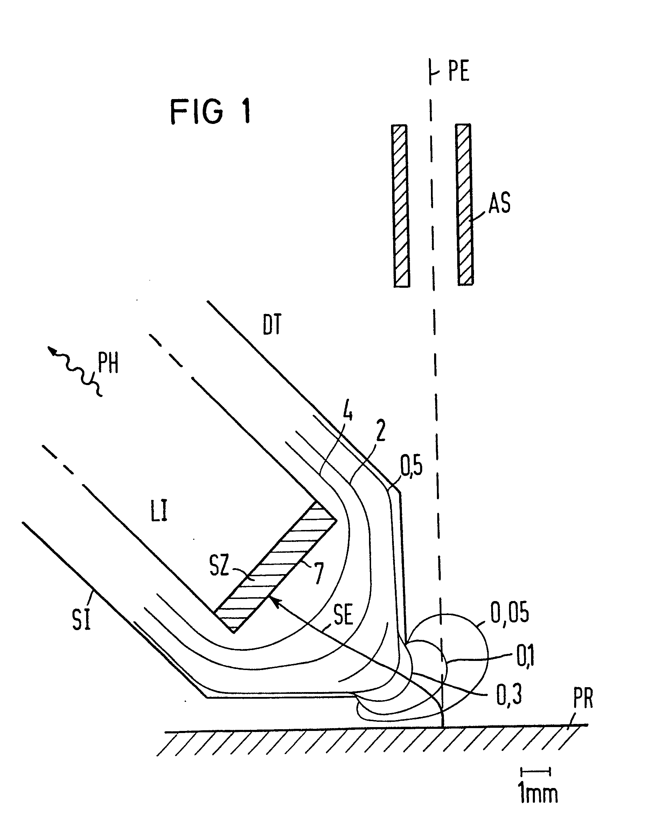

Fig. 1 zeigt schematisch eine erfindungsgemässe Vorrichtung. Der Primär-Elektronenstrahl PE wird mit Hilfe eines elektrostatischen X–Y-Ablenksystems AS auf den jeweils gewünschten Messpunkt auf der Probe PR positioniert. Die an diesem Messpunkt auf der Probe PR ausgelösten Sekundärelektronen SE werden über ein starkes Absaugfeld zum Szintillator SZ des Detektors DT hin beschleunigt. Die in Fig. 1 mit Zahlen bezeichneten Kurven seien näherungsweise angegebene Äquipotentiallinien dieses Absaugfeldes. Die dabei angegebenen Zahlen von 0,05 bis 7 bezeichnen dabei jeweils die Spannung in $10^3$ Volt. Beispielsweise liegt also der Szintillator SZ auf einem Potential von 7000 Volt. Die im Szintillator SZ ausgelösten Photonen PH werden vom Lichtleiter LI zu einem Fotomultiplier und zu einem daran angeschlossenen Vorverstärker weitergeleitet. Der Detektor DT weist eine Abschirmung SI zur Probe PR und zum Primär-Elektronenstrahl PE hin auf. In einem Abstand von wenigen Millimetern zum Messpunkt befindet sich eine Öffnung dieser Abschirmung SI, die einen Durchmesser von wenigen Millimetern aufweist, so dass aus dieser Öffnung das Absaugfeld bis hin zum Messpunkt auf der Probe PR wirksam werden kann. Durch Verwendung eines speziellen Detektors DT mit einem starken Absaugfeld von etwa 250 V/mm oberhalb der Probe PR, beispielsweise einer integrierten Schaltung, kann mit einem schnellen Szintillator SZ, Fotomultiplier und Vorverstärker eine Anstiegszeit für das Sekundärelektronen-Messignal von 1,5 ns erreicht werden. Dies bedeutet eine Bandbreite von 230 MHz bei einer erfindungsgemässen Vorrichtung. Ein solches schnelles, zeitabhängiges Sekundärelektronen-Messignal kann mit Hilfe eines Oszillografen, Transientenrecorders, Logikanalysators oder lock-in-Verstärkers sichtbar gemacht werden bzw. weiterverarbeitet werden.

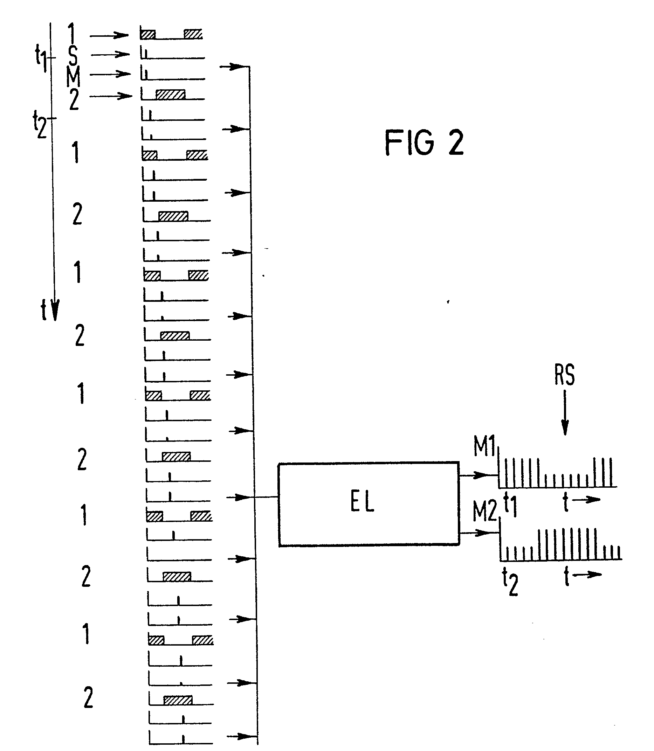

Fig. 2 erläutert das Prinzip eines erfindungsgemässen Verfahrens. Zur Messung an verschiedenen Messpunkten, beispielsweise auf verschiedenen Leiterbahnen mit den Nummern 1, 2, wird ein elektrostatisches X–Y-Ablenksystem AS verwendet, das in wenigen Millimetern Abstand oberhalb der Probe PR, beispielsweise einer integrierten Schaltung, angeordnet ist und den Primär-Elektronenstrahl PE auf den jeweiligen Messpunkt auf der Probe PR positioniert. Der Primär-Elektronenstrahl PE verweilt dabei auf den einzelnen Messpunkten, beispielsweise auf den einzelnen Leiterbahnen, solange, bis im Detektor DT das an dem betreffenden Messpunkt ausgelöste Sekundärelektronen-Messignal im Rauschen erkannt wird. Das resultierende Signal gelangt zu einem Fotomultiplier, sodann zu einem Vorverstärker und kann dann am Ausgang dieses Vorverstärkers über eine elektronische Schaltung EL den einzelnen Messpunkten, beispielsweise den Leiterbahnen mit den Nummern 1, 2, zugeordnet werden.

Diese elektronische Schaltung EL gibt die Signalverläufe M1, M2 an verschiedenen Ausgängen aus, die den jeweiligen Messpunkten entsprechen. Der Signalverlauf M1 entspricht dem Potentialverlauf an der Leiterbahn mit der Nummer 1, der Signalverlauf M2 entspricht dem Potentialverlauf an der Leiterbahn mit der Nummer 2. An der Leiterbahn mit der Nummer 1 liege das zeitabhängige Potential 1 an. Dieses Potential 1 ist in Fig. 2 in Abhängigkeit von der Zeit t eingezeichnet. Zu einer bestimmten Zeit wird der Primär-Elektronenstrahl PE mit einem Strahlstrom S auf die Leiterbahn mit der Nummer 1 positioniert. Dieser Strahlstrom S löst auf dieser Leiterbahn mit der Nummer 1 ein Messignal M aus. Dieses Messignal M wird über die elektronische Schaltung EL dem Signalverlauf M1 mit einer bestimmten Zeit-Koordinate $t_1$ und mit dem für das Messignal M zur Zeit $t_1$ auf der Leiterbahn mit der Nummer 1 gemessenen Wert zugeordnet. Zu einem kurz nach dem Zeitpunkt $t_1$ eintretenden Zeitpunkt $t_2$ ist der Primär-Elektronenstrahl PE auf die Leiterbahn mit der Nummer 2 positioniert. Das zum Zeitpunkt $t_2$ an der Leiterbahn mit der Nummer 2 anliegende Potential wird über ein neues Messignal festgestellt und dieses neue Messignal wird nunmehr mit dem Zeitpunkt $t_2$ dem Signalverlauf M2 zugeordnet. Bei dem in Fig. 2 dargestellten Prinzip eines erfindungsgemässen Verfahrens wird nunmehr der Primär-Elektronenstrahl PE wiederum auf die Leiterbahn mit der Nummer 1 positioniert und nach Zuordnung des dabei erhaltenen Messignals zum Signalverlauf M1 wird der Primär-Elektronenstrahl zu einem noch späteren Zeitpunkt wiederum auf die Leiterbahn mit der Nummer 2 positioniert.

Da in Fig. 2 sowohl für den Potentialverlauf 1 als auch für den Potentialverlauf 2 jeweils genau eine Periode angegeben ist, wird auf diese Weise durch zeitliches Hin- und Herschalten der Position des Primär-Elektronenstrahls PE zwischen der Leiterbahn mit der Nummer 1 und der Leiterbahn mit der Nummer 2 der jeweilige Potentialverlauf 1, 2 in Echtzeit aufgezeichnet. Die Erfindung ermöglicht eine direkte Messung auch bei sehr hochfrequenten Potentialverläufen 1, 2 oder auch bei sehr schnellen, nicht-periodischen Potentialverläufen 1, 2. Zu jedem Zeitpunkt $t_1$, i = 1, 2, . . . , wird ein Messignal M an die elektronische Schaltung EL weitergegeben. Wenn die in Fig. 2 dargestellten Perioden des Potentialverlaufs 1 und des Potentialverlaufs 2 beendet sind, ist auch die Aufzeichnung dieser Perioden der Signalverläufe M1, M2 beendet.

Wie aus der Literatur (N.C. MacDonald, J. Appl. Phys. 40, 1969, 4516–4528) bekannt ist, wird die Bandbreite der Sekundärelektronen-Signalverarbeitung von den Sekundärelektronen-Laufzeitdifferenzen zwischen Messpunkt auf der Probe PR und Detektor DT, der Abklingzeit des Szintillators SZ und der Anstiegszeit von Fotomultiplier und Vorverstärker bestimmt. Wesentlich dabei sind die Sekundärelektronen-Laufzeitdifferenzen zwischen Messpunkt auf der Probe PR und Detektor DT. Die Erfindung hat gerade eine wesentliche Verkürzung der SE-Laufzeitdifferenzen zwischen Messpunkt auf der Probe PR und Detektor DT zur Folge. Gerade deshalb ermöglicht die Erfindung eine wesentliche Erhöhung der Bandbreite der Sekundärelektronen-Signalverarbeitung gegenüber dem Stand der Technik.

**Patentansprüche**

1.Vorrichtung zur direkten Messung von Signalverläufen (1, 2) an mindestens einem Messpunkt auf einer Probe (PR), mit einer Korpuskularsonde (PE), mit einem Ablenksystem (AS) für die Korpuskularsonde (PE), mit einem Detektor (DT) für Sekundärelektronen (SE), dadurch gekennzeichnet,
– dass der Detektor (DT) zur Erzeugung eines starken Absaugfeldes für die Sekundärelektronen (SE) eine Abschirmung (SI) zur Probe (PR) und zur Korpuskularsonde (PE) hin aufweist,
– dass in dieser Abschirmung (SI) eine Öffnung zum Austritt des Absaugfeldes nur in Nachbarschaft zu dem jeweiligen Messpunkt auf der Probe (PR) vorgesehen ist, und
– dass ein elektrostatisches X–Y-Ablenksystem (AS) für die Positionierung der Korpuskularsonde (PE) in wenigen Millimetern Abstand oberhalb der Probe (PR) angeordnet ist.

2. Verfahren zur direkten Messung von Signalverläufen (1, 2) an mindestens einem Messpunkt auf einer Probe (PR), bei dem eine Korpuskularsonde (PE) ein Ablenksystem (AS) durchläuft und auf der Probe (PR) Sekundärelektronen (SE) auslöst und bei dem die Sekundärelektronen (SE) von einem Detektor (DT) nachgewiesen werden, dadurch gekennzeichnet, dass ein elektrostatisches X–Y-Ablenksystem (AS) zu bestimmten Zeitpunkten ($t_1$, $t_2$) die Korpuskularsonde (PE) auf den jeweiligen Messpunkt positioniert, dass die Korpuskularsonde (PE) solange auf dem jeweiligen Messpunkt verweilt, bis im Detektor (DT) das an dem jeweiligen Messpunkt ausgelöste Sekundärelektronen-Signal im Rauschen erkannt wird, dass das resultierende Signal über eine Schaltung (EL) dem jeweiligen Messpunkt mit dem entsprechenden Zeitpunkt ($t_1$, $t_2$) zugeordnet wird, dass die Schaltung (EL) die gemessenen Signalverläufe (M1, M2) so ausgibt, dass sie den jeweiligen Messpunkten zugeordnet werden können.

**Revendications**

1. Dispositif pour la mesure directe d'allures de signaux (1, 2) en au moins un point de mesure sur un échantillon (PR), avec une sonde corpusculaire (PE), avec un système de déviation (AS) pour la sonde corpusculaire (PE), avec un détecteur (DT) pour les électrons secondaires (SE), caractérisé par le fait,
– que le détecteur (DT) comporte, en vue de produire un champ d'aspiration élevé pour les électrons secondaires (SE), un écran (SI) dirigé vers l'échantillon (PR), et vers la sonde corpusculaire (PE),
– que dans cet écran (SI) est prévue une ouverture pour la sortie du champ d'aspiration, uniquement dans le voisinage du point de mesure concerné sur l'échantillon (PR), et

– qu'un système électrostatique de déviation X–Y (AS) pour le positionnement de la sonde corpusculaire (PE) est disposé à une distance de quelques millimètres au-dessus de l'échantillon (PR).

2. Procédé pour la mesure directe d'allures de signaux (1, 2) en au moins un point de mesure sur un échantillon (PR) dans lequel une sonde corpusculaire (PE) passe par un système de déviation et libère sur l'échantillon (PR) des électrons secondaires, et dans lequel les électrons secondaires (SE) sont détectés par un détecteur (DT), caractérisé par le fait qu'un système électrostatique de déviation X–Y (AS) positionne, à des instants déterminants $(t_1, t_2)$ la sonde corpusculaire (PE) sur le point de mesure considéré, que la sonde corpusculaire (PE) reste sur le point de mesure considéré jusqu'à ce que l'on reconnaisse, par le bruit, dans le détecteur (DT) le signal des électrons secondaires qui sont émis au niveau du point de mesure considéré, que le signal résultant est associé, par l'intermédiaire d'un circuit (EL), au point de mesure concerné, à l'instant correspondant $(t_1, t_2)$, que le circuit (EL) émet de telle manière les allures (M1, M2) des signaux qui ont été mesurés, que celles-ci puissent être associées aux points de mesure concernés.

**Claims**

1. A device for directly measuring signal curves (1, 2) at at least one measurement point of a test member (PR), having a corpuscular probe (PE), a deflecting system (AS) for the corpuscular probe (PE) and a detector (DT) for secondary electrons (SE); characterised in that

– in order to produce a strong attraction field for removing the secondary electrons (SE) the detector (DT) is provided with a screen (SI) positioned relative to the test member (PR) and the corpuscular probe (PE),

– that this screen (SI) contains an opening for the outlet of the attraction field solely in the vicinity of the relevant measurement point on the test member (PR) and

– that an electrostatic X–Y deflection system (AS) for positioning the corpuscular probe (PE) is arranged at an interval of a few millimeters above the test member (PR).

2. A method of directly measuring signal curves (1, 2) at at least one measurement point on a test member (PR), where a corpuscular probe (PE) passes through a deflecting system (AS) and excites secondary electrons (SE) from the test member (PR), and wherein the secondary electrons (SE) are detected by a detector (DT), characterised in that at specific times $(t_1, t_2)$ an electrostatic X–Y deflection system (AS) positions the corpuscular probe (PE) at the relevant measurement point, that the corpuscular probe (PE) remains at the relevant measurement point until the secondary electron signal triggered at the measurement point is recognised against the background noise in the detector (DT), that the resultant signal is assigned to the relevant measurement point with the corresponding time $(t_1, t_2)$ via a circuit (EL), and that the circuit (EL) emits the measured signal curves (M1, M2) in such manner that they can be assigned to the measurement times in question.

FIG 1

2/2

FIG 2